Europäisches Patentamt

European Patent Office

Office européen des brevets

(19)

(11) Publication number: **0 329 227**

**A1**

## EUROPEAN PATENT APPLICATION

(12)

(21) Application number: **89200300.5**

(22) Date of filing: **09.02.89**

(51) Int. Cl.⁴: **H01L 21/285 , H01L 21/318 , H01L 21/90**

(30) Priority: **15.02.88 NL 8800359**

(43) Date of publication of application:
**23.08.89 Bulletin 89/34**

(84) Designated Contracting States:
**DE FR GB IT NL**

(71) Applicant: **N.V. Philips' Gloeilampenfabrieken**
**Groenewoudseweg 1**
**NL-5621 BA Eindhoven(NL)**

(72) Inventor: **Wolters, Robertus Adrianus Maria**
**c/o INT. OCTROOIBUREAU B.V. Prof.**
**Holstlaan 6**
**NL-5656 AA Eindhoven(NL)**
Inventor: **Van Oekel, Jacques Jules**
**c/o INT. OCTROOIBUREAU B.V. Prof.**
**Holstlaan 6**
**NL-5656 AA Eindhoven(NL)**
Inventor: **Van Houtum, Hendrikus Josephus**
**W.**
**c/o INT. OCTROOIBUREAU B.V. Prof.**
**Holstlaan 6**
**NL-5656 AA Eindhoven(NL)**

(74) Representative: **Rensen, Jan Geert et al**
**Internationaal Octrooibureau B.V. Prof.**
**Holstlaan 6**
**NL-5656 AA Eindhoven(NL)**

(54) Method of manufacturing a semiconductor device.

(57) The invention relates to a method of manufacturing a semiconductor device, in which a silicon body (1) is contacted successively with a titanium layer (2), a nitrogen-containing titanium layer (3) and an aluminium layer (4).

According to the invention, the nitrogen-containing titanium layer (3) is formed by a short heat treatment in a nitrogen-containing atmosphere from a part of the titanium layer (2), which is a practically very simple method.

FIG.3

## Method of manufacturing a semiconductor device.

The invention relates to a method of manufacturing a semiconductor device, in which a semiconductor body of silicon is contacted at the surface of a silicon-containing part by forming on it in order of succession a titanium layer, a nitrogen-containing titanium layer and an aluminium layer.

Such a method has been described in European Patent Application EP-A2-0,209,654, in which a titanium layer, a titanium nitride layer and an aluminium layer are successively formed on the surface of a silicon body.

The combination of the titanium and titanium nitride layers, provided in the aforementioned order of succession, has between a silicon body and an aluminium layer a good contact resistance with the silicon and substantially no interaction with the aluminium layer.

A combination of a titanium layer and a nitrogen-containing titanium layer is to be preferred to a titanium layer alone because, though the latter has a lower contact resistance with silicon, it is reactive with aluminium.

A combination of a titanium layer and a nitrogen-containing titanium layer is also to be preferred to a nitrogen-containing titanium layer alone because, though the latter is less reactive with aluminium, it has a higher contact resistance with silicon.

In the aforementioned known method, the titanium and titanium nitride layers are formed by sputtering. In such a method, the titanium layer is first formed by sputtering of a thoroughly cleaned titanium target, after which in the same apparatus the titanium nitride layer is formed by sputtering of the same titanium target in a nitrogen-containing atmosphere.

The said sputtering process has the disadvantage that it is complicated. With a clean apparatus, reasonable results can be attained when the method is carried out for the first time, but when the method is carried out for the second time, an impure titanium layer is often obtained by subsequent delivery of nitrogen still present in the apparatus after the method has been carried out for the first time.

In practice, two sputtering chambers would then be required, i.e. one working with nitrogen and one working without nitrogen. Using titanium nitride as target is difficult and poorly reproducible.

With the use of a titanium target in a nitrogen-containing atmosphere, the deposition rate of titanium nitride also strongly decreases soon by nitridation of the titanium target.

The invention has inter alia for its object to avoid the aforementioned disadvantages at least to a great extent.

The invention is based inter alia on the recognition of the fact that improvements are possible by forming the nitrogen-containing titanium layer by a process other than sputtering.

According to the invention, the method mentioned in the opening paragraph is therefore characterized in that the nitrogen-containing titanium layer is formed by converting titanium in a part of the titanium layer adjoining the surface in a short treatment at elevated temperature in a nitrogen-containing atmosphere into the nitrogen-containing titanium layer.

The heat treatment is preferably carried out in 5 to 60 seconds and at a temperature of 300 - 750° C, for example by heating for 30 seconds at a temperature of 550° C and a nitrogen pressure of 1 atm.

It has been found that the part of the titanium layer adjoining the surface need not be converted entirely into titanium nitride to provide as yet the favourable effect of titanium nitride.

The titanium layer can be formed in a usual manner by sputtering. The titanium layer may contain additions of, for

The invention will now be described with reference to an example and the accompanying drawing. In the drawing, Figure 1 and Figure 2 show diagrammatically and in sectional view a part of a semiconductor device at successive stages of manufacture by means of the method according to the invention and Figure 3 shows also diagrammatically and in sectional view another part of a semiconductor device at a stage of manufacture by means of the method according to the invention.

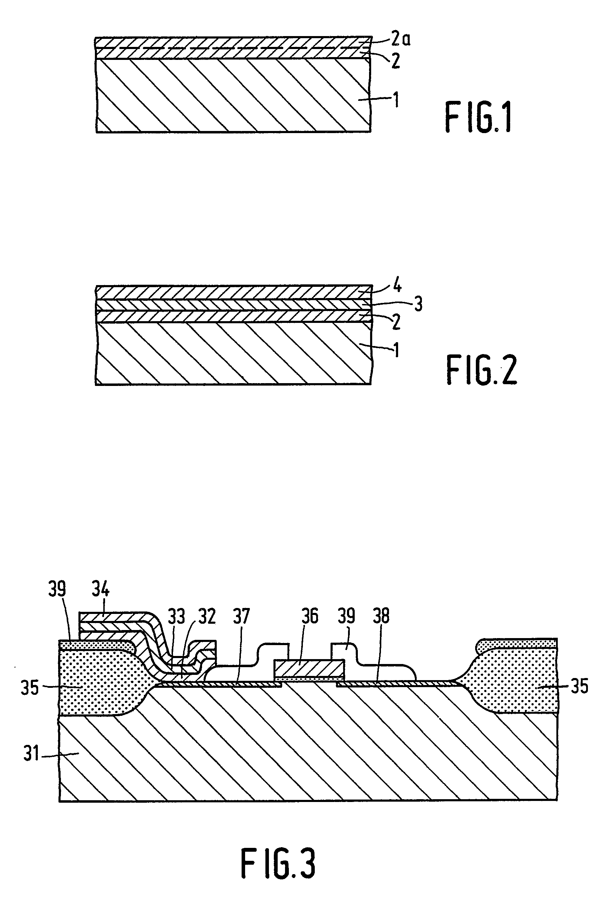

Figures 1 and 2 show that in a method of manufacturing a semiconductor device a semiconductor body 1 of silicon is contacted by forming on it in order of succession a titanium layer 2, a nitrogen-containing titanium layer 3 and an aluminium layer 4. According to the invention, the nitrogen-containing titanium layer 3 is formed by converting titanium in a part 2a of the titanium layer 2 adjoining the surface in a short treatment at elevated temperature in a nitrogen-containing atmosphere into the nitrogen-containing titanium layer 3.

The treatment is so short that the titanium substantially does not attack any underlying silicon oxide, that the titanium at most reacts partly with the underlying silicon and that substantially no oxidation of the titanium by small traces of oxygen, if any, can occur.

Thus, in a comparatively simple manner, a layer system of a titanium layer and a nitrogen-containing titanium layer is obtained, which has a low resistance with silicon and is substantially not reactive with aluminium. A consequence of the low reaction of titanium with silicon oxide in the method according to the invention is that the contacts need not be aligned accurately to the openings in oxide layers and may lie in part over silicon oxide layers present on the surface of the silicon body. .

For example, Figure 3 indicates how a layer system consisting of a titanium layer 32, a nitrogen-containing titanium layer 33 and an aluminium layer 34 contacts a silicon body 31 by means of the method according to the invention. Before the said layers are provided, oxide regions 35 sunken into the silicon body 31, an insulated gate electrode 36, source and drain regions 37 and 38 and an oxide layer 39 are formed in a usual manner.

The titanium layers 2 and 32 are provided by sputtering of titanium and have a thickness of, for example, 0.1 $\mu$m.

During the heat treatment, the semiconductor body is heated for 30 seconds at 550°C in a nitrogen atmosphere and the nitrogen-containing titanium layers 3 and 33 are formed. The titanium layer is then converted over approximately half its thickness. Subsequently, aluminium containing 1% of silicon is deposited in a usual manner in a thickness of about 1 $\mu$m. A desired pattern is then provided also in a usual manner in the aluminium layers, in the nitrogen-containing titanium layers and in the titanium layers.

The invention is of course not limited to the examples given, but may be varied within the scope of the invention by those skilled in the art in many ways. For example, the nitrogen-containing atmosphere may be obtained by the use of nitrogen, ammonia or hydrazine as nitrogen source. The nitrogen or nitrogen compounds may also be rarefied by an inert gas, for example argon. It may be very useful to add besides nitrogen traces of oxygen to the atmosphere in which the heat treatment is carried out, as a result of which the reactivity of the nitrogen-containing titanium layer with aluminium is still further reduced. Instead of directly on silicon, the titanium and nitrogen-containing titanium layers may also be provided on silicide layers, for example titanium or cobalt silicide layers, disposed on the silicon body.

## Claims

1. A method of manufacturing a semiconductor device, in which a semiconductor body of silicon is contacted by forming on it in order of succession a titanium layer, a nitrogen-containing titanium layer and an aluminium layer, characterized in that the nitrogen-containing titanium layer is formed by converting titanium in a part of the titanium layer adjoining the surface in a short treatment at elevated temperature in a nitrogen-containing atmosphere into the nitrogen-containing titanium layer.

2. A method as claimed in Claim 1, characterized in that the heat treatment is carried out in 5 to 60 seconds.

3. A method as claimed in Claim 1 or 2, characterized in that the heat treatment is carried out at a temperature of 300 - 750°C.

4. A method as claimed in any one of the preceding Claims, characterized in that the treatment is carried out by heating for 30 seconds at a temperature of 550°C and a nitrogen pressure of 1 atm.

FIG.1

FIG.2

FIG.3

European Patent
Office

**EUROPEAN SEARCH REPORT**

Application Number

EP 89 20 0300

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| D,Y | EP-A-0 209 654 (K.K. TOSHIBA) <br> * Claim 1 * <br> --- | 1 | H 01 L 21/285 <br> H 01 L 21/318 <br> H 01 L 21/90 |
| Y | IBM TECHNICAL DISCLOSURE BULLETIN, vol. 24, no. 4, September 1981, pages 1976-1977, New York, US; C.Y. TING: "Using titanium nitride and silicon nitride for VLSI contacts" <br> * Page 1976, line 3 * <br> --- | 1 | |
| A | US-A-4 566 026 (E.C. LEE et al.) <br> --- | | |
| A | IBM TECHNICAL DISCLOSURE BULLETIN, vol. 25, no. 2, July 1982, page 572, New York, US; L. BERENBAUM et al.: "Improved junction integrity and contact resistance of shallow junction" <br> ----- | | |

TECHNICAL FIELDS
SEARCHED (Int. Cl.4)

H 01 L

The present search report has been drawn up for all claims

| Place of search | Date of completion of the search | Examiner |
|---|---|---|
| THE HAGUE | 16-05-1989 | ZOLLFRANK G.O. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)